# EUROPEAN PATENT APPLICATION

(11) **EP 1 746 123 A1**
(43) Date of publication of application: **24.01.2007**
(21) Application number: 05739243.3
(22) Date of filing: 11.05.2005
(51) Int. Cl.: C08G 77/50, C08G 77/42, C08L 83/14, C09D 183/14, H01B 3/46, H01L 21/312

(54) **METHOD FOR FORMING ORGANIC SILICA FILM, ORGANIC SILICA FILM, WIRING STRUCTURE, SEMICONDUCTOR DEVICE, AND COMPOSITION FOR FILM FORMATION**

(30) Priority: 11.05.2004 JP 2004141200; 14.01.2005 WO PCT/JP2005/000375
(71) Applicant: JSR Corporation, Tokyo 104-8410 (JP)
(72) Inventor: AKIYAMA, Masahiro, Tokyo 1048410 (JP); KUROSAWA, Takahiko, Tokyo 1048410 (JP); NAKAGAWA, Hisashi, Tokyo 1048410 (JP); SHIOTA, Atsushi, Tokyo 1048410 (JP)
(74) Representative: TBK-Patent
(86) International application number: PCT/JP2005/008608
(87) International publication number: WO 2005/108469

(57) **Abstract**

A method of forming an organic silica film capable of efficiently curing a coating at a lower dose of electron beams in a shorter time at a lower temperature and forming a film which may be suitably used as an interlayer dielectric for semiconductor devices and the like and exhibits a low relative dielectric constant and excellent mechanical strength, adhesion, plasma resistance, and chemical resistance, a film-forming composition used for the method, an organic silica film obtained by the method, a wiring structure including the organic silica film, and a semiconductor device including the wiring structure. A method of forming an organic silica film according to the invention includes forming a coating including a silicon compound having an -Si-O-Si- structure and an -Si-CH₂-Si- structure on a substrate, heating the coating, and curing the coating by applying electron beams.

## Description

### TECHNICAL FIELD

The present invention relates to a method of forming an organic silica film, an organic silica film, a wiring structure, a semiconductor device, and a film-forming composition.

### BACKGROUND ART

A silica (SiO₂) film formed by a vacuum process such as chemical vapor deposition (CVD) has been widely used as an interlayer dielectric for semiconductor devices and the like. In recent years, a coating-type insulating film called a spin-on-glass (SOG) film which contains a tetraalkoxysilane hydrolysate as the main component has also been used in order to form a more uniform interlayer dielectric. Along with an increase in the degree of integration of semiconductor devices, a low-relative-dielectric-constant interlayer dielectric called an organic SOG film has been developed which contains a polyorganosiloxane as the main component.

In particular, an improved electrical insulation between conductors has been demanded accompanying a further increase in the degree of integration and the number of layers of semiconductor devices. Therefore, an interlayer dielectric material has been demanded which exhibits a lower relative dielectric constant and excellent crack resistance, mechanical strength, and adhesion.

However, a known material containing a polysiloxane as the main component is not suitable for production on an industrial scale, since the reaction product exhibits unstable properties and the resulting coating varies to a large extent in relative dielectric constant, crack resistance, mechanical strength, adhesion, and the like.

A technology of improving the performance of an insulating film by using a known polysiloxane as the material and applying electron beams (EB) in addition to heat (United States Patent No. 6,042,994 and United States Patent No. 6,204,201) and a technology of applying electron beams to a polysiloxane having a methyl group to produce an Si-C-Si bond in the film (JP-A-2001-286821) have also been proposed.

When forming a multilayer wiring structure for semiconductor devices, the resulting insulating film is subjected to plasma etching and chemical treatment during processing. An insulating film obtained by the related-art technology exhibits insufficient plasma etching resistance and RIE resistance, even if the insulating film exhibits a low relative dielectric constant and high mechanical strength.

Plasma damage which occurs during processing the insulating film is mainly caused by a phenomenon in which radicals produced by plasma remove CH₃ from an Si-CH₃ structure of a polysiloxane. A silyl radical secondarily produced when CH₃ is removed from the Si-CH₃ structure promptly reacts with an oxygen atom or an oxygen radical present near the silyl radical and attracts hydrogen to form a silanol group (Si-OH). The presence of the silanol group increases the hygroscopicity of the insulating film, whereby an increase in relative dielectric constant, deterioration in chemical resistance, and a decrease in electrical insulating properties occur.

As a method of improving plasma resistance, a method may be considered in which the absolute amount of Si-CH₃ structure in the insulating film is merely increased so that a large amount of CH₃ is removed in the top layer to form a densified layer in the top layer, thereby improving apparent plasma resistance and RIE resistance. However, there is a limit to introduction of the Si-CH₃ structure group into the polysiloxane from the viewpoint of maintaining the performance of the insulating film, particularly the hardness and the modulus of elasticity.

As a material used to form a low-dielectric-constant interlayer dielectric, a composition containing a polycarbosilane or prepared by mixing a polysiloxane and a polycarbosilane has been proposed (JP-A-2001-127152).

This composition aims at improving heat resistance and hygroscopic resistance. When such a material has an Si-OH structure in the polycarbosilane, it is considered that the Si-OH structure exhibits reactivity lower than that of an Si-OH group in the polysiloxane unit due to steric hindrance, limitations to the mobility of an Si-CH₂-Si structure, and the like. Therefore, since it is difficult to form a sufficiently high condensation state by heating, OH groups remain in the resulting insulating film, whereby the insulating film exhibits poor plasma resistance and chemical resistance.
JP-A-2001-127152
JP-A-2001-286821
United States Patent No. 6,042,994
United States Patent No. 6,204,201

### DISCLOSURE OF THE INVENTION

An object of the invention is to provide a method of forming an organic silica film capable of efficiently curing a coating at a lower dose of electron beams in a shorter time at a lower temperature and forming a film which can be suitably used as an interlayer dielectric for semiconductor devices and the like and exhibits a low relative dielectric constant and excellent mechanical strength, adhesion, plasma resistance, and chemical resistance, and a film-forming composition used for the method.

Another object of the invention is to provide an organic silica film obtained by the method of forming an organic silica film according to the invention, a wiring structure including the organic silica film, and a semiconductor device including the wiring structure.

A method of forming an organic silica film according to the invention comprises forming a coating including a silicon compound having an -Si-O-Si- structure and an -Si-CH₂-Si- structure on a substrate, heating the coating, and curing the coating by applying electron beams.

In the above method of forming an organic silica film according to the invention, the silicon compound may contain the -Si-O-Si- structure and the -Si-CH₂-Si- structure at an -Si-CH₂-Si-/-Si-O-Si- ratio (molar ratio) of 0.03 to 2.00.

In the above method of forming an organic silica film according to the invention, the silicon compound may have a carbon content of 13 to 24 mol%.

In the above method of forming an organic silica film according to the invention, the silicon compound may be a hydrolysis-condensation product obtained by hydrolyzing and condensing (B) a hydrolyzable-group-containing silane monomer in the presence of (A) a polycarbosilane.

In the above method of forming an organic silica film according to the invention, the electron beams may be applied at an accelerating voltage of 0.1 to 20 keV and a dose of 1 to 1000 microcurie/cm².

In the above method of forming an organic silica film according to the invention, the coating may be heated while applying the electron beams. In this case, the coating may be heated at 300 to 450°C.

In the above method of forming an organic silica film according to the invention, the electron beams may be applied in the absence of oxygen.

An organic silica film according to the invention may be obtained by the above method of forming an organic silica film according to the invention and have a relative dielectric constant of 1.5 to 3.5 and a film density of 0.7 to 1.3 g/cm³.

A wiring structure according to the invention comprises the above organic silica film according to the invention as an interlayer dielectric.

A semiconductor device according to the invention comprises the above wiring structure according to the invention.

A film-forming composition according to the invention comprises a hydrolysis-condensation product obtained by hydrolyzing and condensing (B) a hydrolyzable-group-containing silane monomer in the presence of (A) a polycarbosilane, and an organic solvent, and is used in the above method of forming an organic silica film according to the invention to form the coating.

In the above film-forming composition according to the invention, the hydrolysis-condensation product may contain carbon atoms in an amount of 13 to 24 mol %.

In the above film-forming composition according to the invention, the amount of the component (B) may be 1 to 1000 parts by weight for 100 parts by weight of the component (A) converted into a complete hydrolysis-condensation product.

The above film-forming composition according to the invention may have a sodium content, a potassium content, and an iron content of 100 ppb or less, respectively.

Since the method of forming an organic silica film according to the invention includes forming the coating including the silicon compound on the substrate, heating the coating, and curing the coating by applying electron beams, the coating can be efficiently cured at a lower dose of electron beams in a shorter time at a lower temperature. This allows provision of an organic silica film which may be suitably used as an interlayer dielectric for semiconductor devices and the like and exhibits a low relative dielectric constant and excellent chemical resistance, plasma resistance, and mechanical strength in a semiconductor manufacturing step.

### BRIEF DESCRIPTION OF THE DRAWINGS

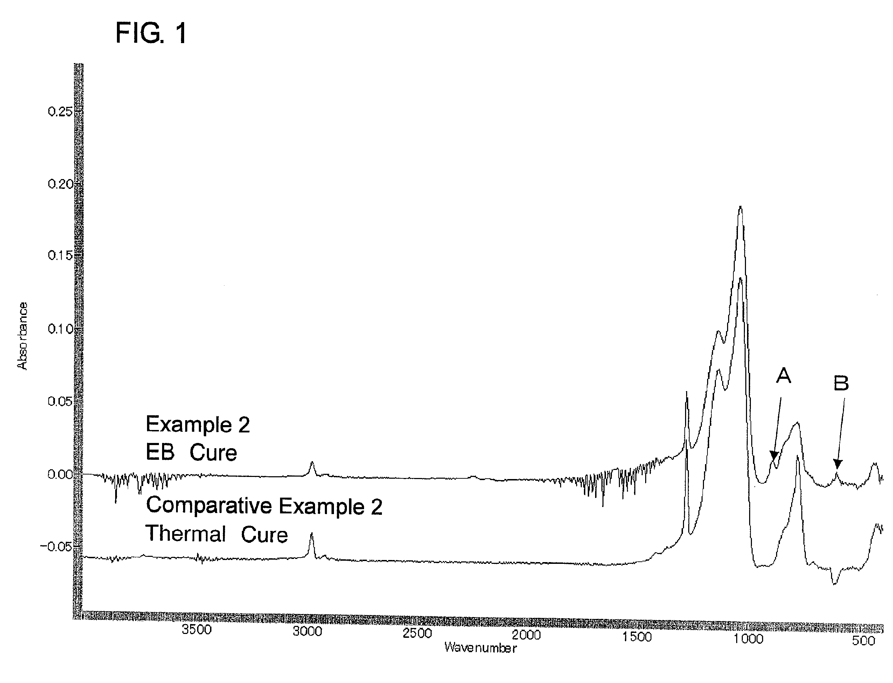

FIG. 1 is a view showing IR spectra of silica films obtained in Example 2 and Comparative Example 2.

### BEST MODE FOR CARRYING OUT THE INVENTION

The invention is described below in more detail.

### 1. Organic silica film and method of forming the same

A method of forming an organic silica film according to the invention includes forming a coating including a silicon compound having an -Si-O-Si- structure and an -Si-CH₂-Si- structure (hereinafter may be simply called "silicon compound") on a substrate, heating the coating, and curing the coating by applying electron beams.

### 1.1. Coating including silicon compound

In the invention, the coating including the silicon compound having an -Si-O-Si-structure and an -Si-CH₂-Si- structure is formed on the substrate.

In the invention, the ratio (molar ratio) of the -Si-CH₂-Si- structure to the -Si-O-Si- structure in the silicon compound is preferably 0.03 to 2.00. If the molar ratio is less than 0.03 or exceeds 2.00, it is difficult to improve plasma resistance and chemical resistance while maintaining a relative dielectric constant and mechanical strength.

In the invention, the number of moles of the -Si-O-Si- structure refers to the number of moles assuming that hydrolyzable silane monomers used are completely hydrolyzed and condensed in a silicon compound formed of a hydrolysis-condensation product described later. The number of moles of the Si-CH₂-Si- structure refers to the number of moles of the -Si-O-Si- structure contained in a polycarbosilane described later.

In the invention, the carbon atom concentration in the coating including the silicon compound is preferably 13 to 24 mol% . If the carbon atom concentration in the silicon compound is less than 13 mol%, the resulting film may not exhibit sufficient plasma resistance and chemical resistance. If the carbon atom concentration exceeds 24 mol%, the resulting film may not exhibit characteristics as an interlayer dielectric in a well-balanced manner.

In the invention, the carbon atom concentration in the coating including the silicon compound refers to the number of carbon atoms in the silicon compound including a hydrolysis-condensation product when hydrolyzable silane monomers described later are completely hydrolyzed and condensed.

The thickness of the coating including the silicon compound is usually 1 to 2000 nm, and preferably 10 to 1000 nm.

In the invention, the coating including the silicon compound may be formed by applying a solution prepared by dissolving a polymer in an organic solvent and drying the applied solution, or may be formed by CVD or the like. It is preferable that the coating including the silicon compound be a film obtained by applying a film-forming composition described below to the substrate and drying the applied composition.

### 1.2. Film-forming composition and method of producing the same

In the invention, a preferred film-forming composition for forming the coating including the silicon compound preferably includes a polycarbosilane and a polysiloxane as polymer components. The film-forming composition according to the invention may be produced by dissolving a polycarbosilane and a polysiloxane in an organic solvent. In particular, it is preferable that the film-forming composition according to the invention be a composition produced by dissolving a hydrolysis-condensation product obtained by hydrolyzing and condensing (B) a hydrolyzable-group-containing silane monomer (hereinafter also called "component (B)") in the presence of (A) a polycarbosilane (hereinafter also called "component (A)") in an organic solvent.

The term "hydrolyzable group" used herein refers to a group which may be hydrolyzed during production of the film-forming composition according to the invention. Specific examples of the hydrolyzable group include a halogen atom, a hydroxyl group, an alkoxy group, a sulfone group, a methanesulfone group, and a trifluoromethanesulfone group. Note that the hydrolyzable group is not limited to these groups. Each component of the film-forming composition according to the invention when the film-forming composition includes the hydrolysis-condensation product and the organic solvent is described below.

### 1.2.1. Hydrolysis-condensation product

The polystyrene-reduced weight average molecular weight (Mw) of the hydrolysis-condensation product is preferably 1500 to 500,000, more preferably 2000 to 200,000, and still more preferably 2000 to 100,000. If the polystyrene-reduced weight average molecular weight of the hydrolysis-condensation product is less than 1,500, the target dielectric constant may not be achieved. If the polystyrene-reduced weight average molecular weight exceeds 500,000, the coating may exhibit poor inplane uniformity.

When producing the hydrolysis-condensation product, the component (A) and the component (B) are mixed at such a ratio that the amount of the component (B) is preferably 1 to 1000 parts by weight, more preferably 5 to 100 parts by weight, and still more preferably 5 to 20 parts by weight for 100 parts by weight of the complete hydrolysis-condensation product of the component (A). If the amount of the component (B) is less than 1 part by weight, the resulting film may not exhibit sufficient chemical resistance. If the amount of the component (B) exceeds 1000 parts by weight, the resulting film may not exhibit a low dielectric constant.

### 1.2.1-1. Component (A)

In the invention, the polycarbosilane (A) (component (A)) may be a polycarbosilane compound of the following general formula (1) (hereinafter also called "compound 1"), for example. 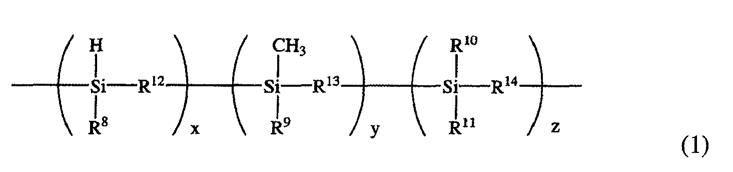 wherein R⁸ represents a group selected from a hydrogen atom, a halogen atom, a hydroxyl group, an alkoxy group, an acyloxy group, a sulfone group, a methanesulfone group, a trifluoromethanesulfone group, an alkyl group, an aryl group, an allyl group, and a glycidyl group, R⁹ represents a group selected from a halogen atom, a hydroxyl group, an alkoxy group, an acyloxy group, a sulfone group, a methanesulfone group, a trifluoromethanesulfone group, an alkyl group, an aryl group, an allyl group, and a glycidyl group, R¹⁰ and R¹¹ individually represent groups selected from a halogen atom, a hydroxyl group, an alkoxy group, an acyloxy group, a sulfone group, a methanesulfone group, a trifluoromethanesulfone group, an alkyl group having 2 to 6 carbon atoms, an aryl group, an allyl group, and a glycidyl group, R¹² to R¹⁴ individually represent a substituted or unsubstituted methylene group, an alkylene group, an alkenyl group, and alkynyl group, or arylene group, and x, y, and z individually represent integers from 0 to 10,000, provided that 5<x+y+z< 10,000 is satisfied.

As examples of the alkylene group in the general formula (1), an ethylene group, a propylene group, a butylene group, a hexylene group, a decylene group, and the like can be given. The alkylene group preferably includes 2 to 6 carbon atoms. The alkylene group may be either linear or branched, or may form a ring. A hydrogen atom of the alkylene group may be replaced with a fluorine atom or the like.

As examples of the alkenyl group in the general formula (1), an ethenylene group, a propenylene group, a 1-butenylene group, a 2-butenylene group, and the like can be given. The alkenyl group may be a dienylene group. The alkenyl group preferably includes 1 to 4 carbon atoms. A hydrogen atom of the alkenyl group may be replaced with a fluorine atom or the like. As examples of the alkynyl group, an acetylene group, a propynylene group, and the like can be given. As examples of the arylene group, a phenylene group, a naphthylene group, and the like can be given. A hydrogen atom of the arylene group may be replaced with a fluorine atom or the like. R⁸ to R¹¹ may be either the same or different groups.

In the general formula (1), x, y, and z individually represent integers from 0 to 10,000, provided that 5<x+y+z<10,000. If x+y+z<5, the film-forming composition may exhibit poor storage stability. If 10,000<x+y+z, the component (B) may be separated from the component (A), whereby a uniform film may not be formed. It is preferable that x, y, and z be respectively 0≤x≤800, 0≤y≤500, and 0≤z≤1000, more preferably 0≤x≤500, 0≤y≤300, and 0≤z≤500, and still more preferably 0≤x≤100, 0≤y≤50, and 0≤z≤100.

It is preferable that x, y, and z satisfy 5<x+y+z<1000, more preferably 5<x+y+z<500, still more preferably 5<x+y+z<250, and most preferably 5<x+y+z<100.

The compound of the general formula (1) may be obtained by reacting at least one compound selected from chloromethyltrichlorosilane, bromomethyltrichlorosilane, chloromethylmethyldichlorosilane, chloromethylethyldichlorosilane, chloromethylvinyldichlorosilane, chloromethylphenyldichlorosilane, bromomethylmethyldichlorosilane, bromomethylvinyldichlorosilane, chloromethyldimethylchlorosilane, chloromethyldivinylchlorosilane, bromomethyldimethylchlorosilane, (1-chloroethyl)trichlorosilane, (1-chloropropyl)trichlorosilane, chloromethyltrimethoxysilane, bromomethyltrimethoxysilane, chloromethylmethyldimethoxysilane, chloromethylvinyldimethoxysilane, chloromethylphenyldimethoxysilane, bromomethylmethyldimethoxysilane, bromomethylvinyldimethoxysilane, bromomethylphenyldimethoxysilane, chloromethyldimethylmethoxysilane, chloromethyldivinylmethoxysilane, chloromethyldiphenylmethoxysilane, bromomethyldimethylmethoxysilane, bromomethyldiisopropylmethoxysilane, chloromethyltriethoxysilane, bromomethyltriethoxysilane, chloromethylmethyldiethoxysilane, chloromethylethyldiethoxysilane, chloromethylvinyldiethoxysilane, chloromethylphenyldiethoxysilane, bromomethylmethyldiethoxysilane, bromomethylvinyldiethoxysilane, bromomethylphenyldiethoxysilane, chloromethyldimethylethoxysilane, chloromethyldiethylethoxysilane, bromomethyldivinylethoxysilane, chloromethyltriisopropoxysilane, and bromomethyltriisopropoxysilane in the presence of at least one of an alkali metal and an alkaline earth metal, followed by an optional treatment with an alcohol, an organic acid, a reducing agent, or the like.

As the alkali metal, Li, Na, and K are preferable. As the alkaline earth metal, Mg and the like are preferable.

### 1.2.1-2. Hydrolyzable group-containing silane monomer (B)

In the invention, the hydrolyzable group-containing silane monomer (B) is not particularly limited insofar as the silane monomer contains a hydrolyzable group. For example, the hydrolyzable group-containing silane monomer (B) may be at least one silane compound selected from a compound of the following general formula (2) (hereinafter also called "compound 2") and a compound of the following general formula (3) (hereinafter also called "compound 3").

R¹ₐSiX₄₋ₐ (2)

wherein R¹ represents a hydrogen atom, a fluorine atom, or a monovalent organic group, X represents a halogen atom or an alkoxy group, and a represents an integer from 0 to 3.

R²_{b}Y_{3-b}Si-(R⁴)_{d}-SiZ_{3-c}R³_{c} (3)

wherein R² and R³ individually represent monovalent organic groups, b and c individually represent integers from 0 to 2, R⁴ represents an oxygen atom, a phenylene group, or a group -(CH₂)ₑ- (wherein e represents an integer from 1 to 6), Y and Z individually represent a halogen atom or an alkoxy group, and d represents 0 or 1.

As examples of the halogen atom represented by X and Y in the general formulas (2) and (3), a fluorine atom, a chlorine atom, a bromine atom, and an iodine atom can be given. As R of the alkoxy group (-OR) represented by Y in the general formula (3), an alkyl group and an aryl group given later as examples for R¹ to R⁴ can be given.

### 1.2.1-2A. Compound 2

In the general formula (2), R¹ represents a hydrogen atom, a fluorine atom, or a monovalent organic group. As examples of the monovalent organic group, an alkyl group, an alkenyl group, an aryl group, an allyl group, a glycidyl group, and the like can be given. In the general formula (2), R² preferably represents a monovalent organic group, and particularly preferably an alkyl group or a phenyl group.

As examples of the alkyl group, a methyl group, an ethyl group, a propyl group, a butyl group, and the like can be given. The alkyl group preferably includes 1 to 5 carbon atoms. The alkyl group may be either linear or branched. A hydrogen atom of the alkyl group may be replaced with a fluorine atom, an amino group, or the like.

As examples of the alkenyl group, a vinyl group, a propenyl group, a 3-butenyl group, a 3-pentenyl group, a 3-hexenyl group, and the like can be given.

As examples of the aryl group, a phenyl group, a naphthyl group, a methylphenyl group, an ethylphenyl group, a chlorophenyl group, a bromophenyl group, a fluorophenyl group, and the like can be given.

The hydrocarbon portion of the alkoxy group represented by X may be the group given as the monovalent organic group represented by R².

Specific examples of the compound of the general formula (2) (hereinafter also called "compound 2") include silicon compounds such as tetramethoxysilane, tetraethoxysilane, tetra-n-propoxysilane, tetra-iso-propoxysilane, tetra-n-butoxysilane, tetra-sec-butoxysilane, tetra-tert-butoxysilane, tetraphenoxysilane, trimethoxysilane, triethoxysilane, tri-n-propoxysilane, tri-iso-propoxysilane, tri-n-butoxysilane, tri-sec-butoxysilane, tri-tert-butoxysilane, triphenoxysilane, fluorotrimethoxysilane, fluorotriethoxysilane, fluorotri-n-propoxysilane, fluorotri-iso-propoxysilane, fluorotri-n-butoxysilane, fluorotri-sec-butoxysilane, fluorotri-tert-butoxysilane, fluorotriphenoxysilane, methyltrimethoxysilane, methyltriethoxysilane, methyltri-n-propoxysilane, methyltri-iso-propoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltri-iso-propoxysilane, ethyltri-n-butoxysilane, ethyltri-sec-butoxysilane, ethyltri-tert-butoxysilane, ethyltriphenoxysilane, vinyltrimethoxysilane, vinyltriethoxysilane, vinyltri-n-propoxysilane, vinyltri-iso-propoxysilane, vinyltri-n-butoxysilane, vinyltri-sec-butoxysilane, vinyltri-tert-butoxysilane, vinyltriphenoxysilane, n-propyltrimethoxysilane, n-propyltriethoxysilane, n-propyltri-n-propoxysilane, n-propyltri-iso-propoxysilane, n-propyltri-n-butoxysilane, n-propyltri-sec-butoxysilane, n-propyltri-tert-butoxysilane, n-propyltriphenoxysilane, i-propyltrimethoxysilane, i-propyltriethoxysilane, i-propyltri-n-propoxysilane, i-propyltri-iso-propoxysilane, i-propyltri-n-butoxysilane, i-propyltri-sec-butoxysilane, i-propyltri-tert-butoxysilane, i-propyltriphenoxysilane, n-butyltrimethoxysilane, n-butyltriethoxysilane, n-butyltri-n-propoxysilane, n-butyltri-iso-propoxysilane, n-butyltri-n-butoxysilane, n-butyltri-sec-butoxysilane, n-butyltri-tert-butoxysilane, n-butyltriphenoxysilane, sec-butyltrimethoxysilane, sec-butyltriethoxysilane, sec-butyl-tri-n-propoxysilane, sec-butyl-tri-iso-propoxysilane, sec-butyl-tri-n-butoxysilane, sec-butyl-tri-sec-butoxysilane, sec-butyl-tri-tert-butoxysilane, sec-butyl-triphenoxysilane, t-butyltrimethoxysilane, t-butyltriethoxysilane, t-butyltri-n-propoxysilane, t-butyltri-iso-propoxysilane, t-butyltri-n-butoxysilane, t-butyltri-sec-butoxysilane, t-butyltri-tert-butoxysilane, t-butyltriphenoxysilane, phenyltrimethoxysilane, phenyltriethoxysilane, phenyltri-n-propoxysilane, phenyltri-iso-propoxysilane, phenyltri-n-butoxysilane, phenyltri-sec-butoxysilane, phenyltri-tert-butoxysilane, phenyltriphenoxysilane, vinyltrimethoxysilane, vinyltriethoxysilane, gamma-aminopropyltrimethoxysilane, gamma-aminopropyltriethoxysilane, gamma-glycidoxypropyltrimethoxysilane, gamma-glycidoxypropyltriethoxysilane, gamma-trifluoropropyltrimethoxysilane, gamma-trifluoropropyltriethoxysilane, dimethyldimethoxysilane, dimethyldiethoxysilane, dimethyl-di-n-propoxysilane, dimethyl-di-iso-propoxysilane, dimethyl-di-n-butoxysilane, dimethyl-di-sec-butoxysilane, dimethyl-di-tert-butoxysilane, dimethyldiphenoxysilane, diethyldimethoxysilane, diethyldiethoxysilane, diethyl-di-n-propoxysilane, diethyl-di-iso-propoxysilane, diethyl-di-n-butoxysilane, diethyl-di-sec-butoxysilane, diethyl-di-tert-butoxysilane, diethyl-di-phenoxysilane, di-n-propyldimethoxysilane, di-n-propyldiethoxysilane, di-n-propyl-di-n-propoxysilane, di-n-propyl-di-iso-propoxysilane, di-n-propyl-di-n-butoxysilane, di-n-propyl-di-sec-butoxysilane, di-n-propyl-di-tert-butoxysilane, di-n-propyl-di-phenoxysilane, di-iso-propyldimethoxysilane, di-iso-propyldiethoxysilane, di-iso-propyl-di-n-propoxysilane, di-iso-propyl-di-iso-propoxysilane, di-iso-propyl-di-n-butoxysilane, di-iso-propyl-di-sec-butoxysilane, di-iso-propyl-di-tert-butoxysilane, di-iso-propyl-di-phenoxysilane, di-n-butyldimethoxysilane, di-n-butyldiethoxysilane, di-n-butyl-di-n-propoxysilane, di-n-butyl-di-iso-propoxysilane, di-n-butyl-di-n-butoxysilane, di-n-butyl-di-sec-butoxysilane, di-n-butyl-di-tert-butoxysilane, di-n-butyl-di-phenoxysilane, di-sec-butyldimethoxysilane, di-sec-butyldiethoxysilane, di-sec-butyl-di-n-propoxysilane, di-sec-butyl-di-iso-propoxysilane, di-sec-butyl-di-n-butoxysilane, di-sec-butyl-di-sec-butoxysilane, di-sec-butyl-di-tert-butoxysilane, di-sec-butyl-di-phenoxysilane, di-tert-butyldimethoxysilane, di-tert-butyldiethoxysilane, di-tert-butyl-di-n-propoxysilane, di-tert-butyl-di-iso-propoxysilane, di-tert-butyl-di-n-butoxysilane, di-tert-butyl-di-sec-butoxysilane, di-tert-butyl-di-tert-butoxysilane, di-tert-butyl-di-phenoxysilane, diphenyldimethoxysilane, diphenyl-di-ethoxysilane, diphenyl-di-n-propoxysilane, diphenyl-di-iso-propoxysilane, diphenyl-di-n-butoxysilane, diphenyl-di-sec-butoxysilane, diphenyl-di-tert-butoxysilane, diphenyldiphenoxysilane, divinyltrimethoxysilane, tetrachlorosilane, tetrabromosilane, tetraiodosilane, trichlorosilane, tribromosilane, triiodosilane, methyltrichlorosilane, ethyltrichlorosilane, n-propyltrichlorosilane, isopropyltrichlorosilane, n-butyltrichlorosilane, t-butyltrichlorosilane, cyclohexyltrichlorosilane, phenethyltrichlorosilane, 2-norbornyltrichlorosilane, vinyltrichlorosilane, phenyltrichlorosilane, methyltribromosilane, ethyltribromosilane, n-propyltribromosilane, isopropyltribromosilane, n-butyltribromosilane, t-butyltribromosilane, cyclohexyltribromosilane, phenethyltribromosilane, 2-norbornyltribromosilane, vinyltribromosilane, phenyltribromosilane, methyltriiodosilane, ethyltriiodosilane, n-propyltriiodosilane, isopropyltriiodosilane, n-butyltriiodosilane, t-butyltriiodosilane, cyclohexyltriiodosilane, phenethyltriiodosilane, 2-norbornyltriiodosilane, vinyltriiodosilane, phenyltriiodosilane, dimethyldichlorosilane, diethyldichlorosilane, di-n-propyldichlorosilane, diisopropyldichlorosilane, di-n-butyldichlorosilane, di-t-butyldichlorosilane, dicyclohexyldichlorosilane, diphenethyldichlorosilane, di-2-norbornyldichlorosilane, divinyldichlorosilane, diphenyldichlorosilane, dimethyldibromosilane, diethyldibromosilane, di-n-propyldibromosilane, diisopropyldibromosilane, di-n-butyldibromosilane, di-t-butyldibromosilane, dicyclohexyldibromosilane, diphenethyldibromosilane, di-2-norbornyldibromosilane, divinyldibromosilane, diphenyldibromosilane, dimethyldiiodosilane, diethyldiiodosilane, di-n-propyldiiodosilane, diisopropyldiiodosilane, di-n-butyldiiodosilane, di-t-butyldiiodosilane, dicyclohexyldiiodosilane, diphenethyldiiodosilane, di-2-norbornyldiiodosilane, divinyldiiodosilane, diphenyldiiodosilane, trimethylchlorosilane, triethylchlorosilane, tri-n-propylchlorosilane, triisopropylchlorosilane, tri-n-butylchlorosilane, tri-t-butylchlorosilane, tricyclohexylchlorosilane, triphenethylchlorosilane, tri-2-norbornylchlorosilane, trivinylchlorosilane, triphenylchlorosilane, trimethylbromosilane, triethylbromosilane, tri-n-propylbromosilane, triisopropylbromosilane, tri-n-butylbromosilane, tri-t-butylbromosilane, tricyclohexylbromosilane, triphenethylbromosilane, tri-2-norbornylbromosilane, trivinylbromosilane, triphenylbromosilane, trimethyliodosilane, triethyliodosilane, tri-n-propyliodosilane, triisopropyliodosilane, tri-n-butyliodosilane, tri-t-butyliodosilane, tricyclohexyliodosilane, triphenethyliodosilane, tri-2-norbornyliodosilane, trivinyliodosilane, and triphenyliodosilane. These compounds may be used either individually or in combination of two or more.

The compound 2 is preferably methyltrimethoxysilane, methyltriethoxysilane, methyltri-n-propoxysilane, methyltri-iso-propoxysilane, ethyltrimethoxysilane, ethyltriethoxysilane, vinyltrimethoxysilane, vinyltriethoxysilane, phenyltrimethoxysilane, phenyltriethoxysilane, dimethyldimethoxysilane, dimethyldiethoxysilane, diethyldimethoxysilane, diethyldiethoxysilane, diphenyldimethoxysilane, diphenyldiethoxysilane, or the like.

These compounds may be used either individually or in combination of two or more.

### 1.2.1-2B. Compound 3

As examples of the monovalent organic groups represented by R² and R³ in the general formula (3), the organic groups given as examples for the general formula (2) can be given.

As examples of the compound of the general formula (3) in which R⁴ is an oxygen atom, hexachlorodisiloxane, hexabromodisiloxane, hexaiodedisiloxane, hexamethoxydisiloxane, hexaethoxydisiloxane, hexaphenoxydisiloxane, 1,1,1,3,3-pentamethoxy-3-methyldisiloxane, 1,1,1,3,3-pentaethoxy-3-methyldisiloxane, 1,1,1,3,3-pentaphenoxy-3-methyldisiloxane, 1,1,1,3,3-pentamethoxy-3-ethyldisiloxane, 1,1,1,3,3-pentaethoxy-3-ethyldisiloxane, 1,1,1,3,3-pentaphenoxy-3-ethyldisiloxane, 1,1,1,3,3-pentamethoxy-3-phenyldisiloxane, 1,1,1,3,3-pentaethoxy-3-phenyldisiloxane, 1,1,1,3,3-pentaphenoxy-3-phenyldisiloxane, 1,1,3,3-tetramethoxy-1,3-dimethyldisiloxane, 1,1,3,3-tetraethoxy-1,3-dimethyldisiloxane, 1,1,3,3-tetraphenoxy-1,3-dimethyldisiloxane, 1,1,3,3-tetramethoxy-1,3-diethyldisiloxane, 1,1,3,3-tetraethoxy-1,3-diethyldisiloxane, 1,1,3,3-tetraphenoxy-1,3-diethyldisiloxane, 1,1,3,3-tetramethoxy-1,3-diphenyldisiloxane, 1,1,3,3-tetraethoxy-1,3-diphenyldisiloxane, 1,1,3,3-tetraphenoxy-1,3-diphenyldisiloxane, 1,1,3-trimethoxy-1,3,3-trimethyldisiloxane, 1,1,3-triethoxy-1,3,3-trimethyldisiloxane, 1,1,3-triphenoxy-1,3,3-trimethyldisiloxane, 1,1,3-trimethoxy-1,3,3-triethyldisiloxane, 1,1,3-triethoxy-1,3,3-triethyldisiloxane, 1,1,3-triphenoxy-1,3,3-triethyldisiloxane, 1,1,3-trimethoxy-1,3,3-triphenyldisiloxane, 1,1,3-triethoxy-1,3,3-triphenyldisiloxane, 1,1,3-triphenoxy-1,3,3-triphenyldisiloxane, 1,3-dimethoxy-1,1,3,3-tetramethyldisiloxane, 1,3-diethoxy-1,1,3,3-tetramethyldisiloxane, 1,3-diphenoxy-1,1,3,3-tetramethyldisiloxane, 1,3-dimethoxy-1,1,3,3-tetraethyldisiloxane, 1,3-diethoxy-1,1,3,3-tetraethyldisiloxane, 1,3-diphenoxy-1,1,3,3-tetraethyldisiloxane, 1,3-dimethoxy-1,1,3,3-tetraphenyldisiloxane, 1,3-diethoxy-1,1,3,3-tetraphenyldisiloxane, 1,3-diphenoxy-1,1,3,3-tetraphenyldisiloxane, and the like can be given.

Of these, hexamethoxydisiloxane, hexaethoxydisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane, 1,3-diethoxy-1,1,3,3-tetraphenyldisiloxane, and the like are preferable.

As examples of the compound of the general formula (3) in which d is zero, hexachlorodisilane, hexabromodisilane, hexaiodedisilane, hexamethoxydisilane, hexaethoxydisilane, hexaphenoxydisilane, 1,1,1,2,2-pentamethoxy-2-methyldisilane, 1,1,1,2,2-pentaethoxy-2-methyldisilane, 1,1,1,2,2-pentaphenoxy-2-methyldisilane, bis(tri-n-butoxysilyl)methane, bis(tri-sec-butoxysilyl)methane, bis(tri-t-butoxysilyl)methane, 1,2-bis(trimethoxysilyl)ethane, 1,2-bis(triethoxysilyl)ethane, 1,2-bis(tri-n-propoxysilyl)ethane, 1,2-bis(tri-i-propoxysilyl)ethane, 1,2-bis(tri-n-1,butoxysilyl)ethane, 1,2-bis(tri-sec-butoxysilyl)ethane, 1,1,2,2-bis(tri-t-butoxysilyl)ethane, 1-(dimethoxymethylsilyl)-1-(trimethoxysilyl)methane, 1-(diethoxymethylsilyl)-1-(triethoxysilyl)methane, 1-(di-n-propoxymethylsilyl)-1-(tri-n-propoxysilyl)methane, 1-(di-i-propoxymethylsilyl)-1-(tri-i-propoxysilyl)methane, 1-(di-n-butoxymethylsilyl)-1-(tri-n-butoxysilyl)methane, 1-(di-sec-butoxymethylsilyl)-1-(tri-sec-butoxysilyl)methane, 1-(di-t-butoxymethylsilyl)-1-(tri-t-butoxysilyl) methane, 1-(dimethoxymethylsilyl)-2-(trimethoxysilyl)ethane, 1-(diethoxymethylsilyl)-2-(triethoxysilyl)ethane, 1-(di-n-propoxymethylsilyl)-2-(tri-n-propoxysilyl)ethane, 1-(di-i-propoxymethylsilyl)-2-(tri-i-propoxysilyl)ethane, 1-(di-n-butoxymethylsilyl)-2-(tri-n-butoxysilyl)ethane, 1-(di-sec-butoxymethylsilyl)-2-(tri-sec-butoxysilyl)ethane, 1-(di-t-butoxymethylsilyl)-2-(tri-t-butoxysilyl)ethane, bis(dimethoxymethylsilyl)methane, bis(diethoxymethylsilyl)methane, bis(di-n-propoxymethylsilyl)methane, bis(di-i-propoxymethylsilyl)methane, bis(di-n-butoxymethylsilyl)methane, bis(di-sec-butoxymethylsilyl)methane, bis(di-t-butoxymethylsilyl)methane, 1,2-bis(dimethoxymethylsilyl)ethane, 1,2-bis(diethoxymethylsilyl)ethane, 1,2-bis(di-n-propoxymethylsilyl)ethane, 1,2-bis(di-i-propoxymethylsilyl)ethane, 1,2-bis(di-n-butoxymethylsilyl)ethane, 1,2-bis(di-sec-butoxymethylsilyl)ethane, 1,2-bis(di-t-butoxymethylsilyl)ethane, 1,2-bis(trimethoxysilyl)benzene, 1,2-bis(triethoxysilyl)benzene, 1,1,1,2,2-pentamethoxy-2-ethyldisilane, 1,1,1,2,2-pentaethoxy-2-ethyldisilane, 1,1,1,2,2-pentaphenoxy-2-ethyldisilane, 1,1,1,2,2-pentamethoxy-2-phenyldisilane, 1,1,1,2,2-pentaethoxy-2-phenyldisilane, 1,1,1,2,2-pentaphenoxy-2-phenyldisilane, 1,1,2,2-tetramethoxy-1,2-dimethyldisilane, 1,1,2,2-tetraethoxy-1,2-dimethyldisilane, 1,1,2,2-tetraphenoxy-1,2-dimethyldisilane, 1,1,2,2-tetramethoxy-1,2-diethyldisilane, 1,1,2,2-tetraethoxy-1,2-diethyldisilane, 1,1,2,2-tetraphenoxy-1,2-diethyldisilane, 1,1,2,2-tetramethoxy-1,2-diphenyldisilane, 1,1,2,2-tetraethoxy-1,2-diphenyldisilane, 1,1,2,2-tetraphenoxy-1,2-diphenyldisilane, 1,1,2-trimethoxy-1,2,2-trimethyldisilane, 1,1,2-triethoxy-1,2,2-trimethyldisilane, 1,1,2-triphenoxy-1,2,2-trimethyldisilane, 1,1,2-trimethoxy-1,2,2-triethyldisilane, 1,1,2-triethoxy-1,2,2-triethyldisilane, 1,1,2-triphenoxy-1,2,2-triethyldisilane, 1,1,2-trimethoxy-1,2,2-triphenyldisilane, 1,1,2-triethoxy-1,2,2-triphenyldisilane, 1,1,2-triphenoxy-1,2,2-triphenyldisilane, 1,2-dimethoxy-1,1,2,2-tetramethyldisilane, 1,2-diethoxy-1,1,2,2-tetramethyldisilane, 1,2-diphenoxy-1,1,2,2-tetramethyldisilane, 1,2-dimethoxy-1,1,2,2-tetraethyldisilane, 1,2-diethoxy-1,1,2,2-tetraethyldisilane, 1,2-diphenoxy-1,1,2,2-tetraethyldisilane, 1,2-dimethoxy-1,1,2,2-tetraphenyldisilane, 1,2-diethoxy-1,1,2,2-tetraphenyldisilane, 1,2-diphenoxy-1,1,2,2-tetraphenyldisilane, and the like can be given.

Of these, hexamethoxydisilane, hexaethoxydisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, 1,2-diethoxy-1,1,2,2-tetraphenyldisilane, and the like are preferable.

As examples of the compound of the general formula (3) in which R⁴ is the group -(CH₂)ₑ-, bis(trichlorosilyl)methane, bis(tribromosilyl)methane, bis(triiodosilyl)methane, bis(trichlorosilyl)ethane, bis(tribromosilyl)ethane, bis(triiodosilyl)ethane, bis(trimethoxysilyl)methane, bis(triethoxysilyl)methane, bis(tri-n-propoxysilyl)methane, bis(tri-i-propoxysilyl)methane, 1,2-bis(tri-n-propoxysilyl)benzene, 1,2-bis(tri-i-propoxysilyl)benzene, 1,2-bis(tri-n-butoxysilyl)benzene, 1,2-bis(tri-sec-butoxysilyl)benzene, 1,2-bis(tri-t-butoxysilyl)benzene, 1,3-bis(trimethoxysilyl)benzene, 1,3-bis(triethoxysilyl)benzene, 1,3-bis(tri-n-propoxysilyl)benzene, 1,3-bis(tri-i-propoxysilyl)benzene, 1,3-bis(tri-n-butoxysilyl)benzene, 1,3-bis(tri-sec-butoxysilyl)benzene, 1,3-bis(tri-t-butoxysilyl)benzene, 1,4-bis(trimethoxysilyl)benzene, 1,4-bis(triethoxysilyl)benzene, 1,4-bis(tri-n-propoxysilyl)benzene, 1,4-bis(tri-i-propoxysilyl)benzene, 1,4-bis(tri-n-butoxysilyl)benzene, 1,4-bis(tri-sec-butoxysilyl)benzene, 1,4-bis(tri-t-butoxysilyl)benzene, and the like can be given.

Of these, bis(trimethoxysilyl)methane, bis(triethoxysilyl)methane, 1,2-bis(trimethoxysilyl)ethane, 1,2-bis(triethoxysilyl)ethane, 1-(dimethoxymethylsilyl)-1-(trimethoxysilyl)methane, 1-(diethoxymethylsilyl)-1-(triethoxysilyl)methane, 1-(dimethoxymethylsilyl)-2-(trimethoxysilyl)ethane, 1-(diethoxymethylsilyl)-2-(triethoxysilyl)ethane, bis(dimethoxymethylsilyl)methane, bis(diethoxymethylsilyl)methane, 1,2-bis(dimethoxymethylsilyl)ethane, 1,2-bis(diethoxymethylsilyl)ethane, 1,2-bis(trimethoxysilyl)benzene, 1,2-bis(triethoxysilyl)benzene, 1,3-bis(trimethoxysilyl)benzene, 1,3-bis(triethoxysilyl)benzene, 1,4-bis(trimethoxysilyl)benzene, 1,4-bis(triethoxysilyl)benzene, and the like are preferable.

The compounds 2 and 3 may be used either individually or in combination of two or more.

When hydrolyzing and condensing at least one silane compound selected from the group consisting of the compounds 2 and 3 in the presence of the polymers (I) to (IV), it is preferable to use water in an amount of more than 0.5 mol and 150 mol or less, and particularly preferably more than 0.5 mol and 130 mol or less for 1 mol of the compounds 2 and 3.

### 1.2.1- 3. Method of producing hydrolysis-condensation product

The hydrolysis-condensation product according to the invention is obtained by hydrolyzing and condensing the component (A) in the presence of the component (B).

The component (A) may be hydrolyzed in a state in which the component (A) and the component (B) are dissolved in an organic solvent. As examples of the organic solvent which may be used, methanol, ethanol, propanol, butanol, tetrahydrofuran, gamma-butyrolactone, propylene glycol monoalkyl ether, and ethylene glycol monoalkyl ether can be given.

The hydrolysis-condensation temperature is 0 to 100°C, and preferably 20 to 60°C, and the reaction time is 30 minutes to 24 hours, and preferably 1 to 8 hours.

A specific catalyst may be used when producing the hydrolysis-condensation product by hydrolyzing and condensing the component (B) in the presence of the component (A). As the catalyst, at least one catalyst selected from the group consisting of an alkali catalyst, a metal chelate catalyst, and an acid catalyst may be used.

As examples of the alkali catalyst, sodium hydroxide, potassium hydroxide, lithium hydroxide, pyridine, pyrrole, piperazine, pyrrolidine, piperidine, picoline, monoethanolamine, diethanolamine, dimethyl monoethanolamine, monomethyldiethanolamine, triethanolamine, diazabicyclooctane, diazabicyclononane, diazabicycloundecene, tetramethylammonium hydroxide, tetraethylammonium hydroxide, tetrapropylammonium hydroxide, tetrabutylammonium hydroxide, ammonia, methylamine, ethylamine, propylamine, butylamine, pentylamine, hexylamine, pentylamine, octylamine, nonylamine, decylamine, N,N-dimethylamine, N,N-diethylamine, N,N-dipropylamine, N,N-dibutylamine, trimethylamine, triethylamine, tripropylamine, tributylamine, cyclohexylamine, trimetylimidine, 1-amino-3-methylbutane, dimethylglycine, 3-amino-3-methylamine, and the like can be given. The alkali catalyst is preferably an amine or an amine salt, particularly preferably an organic amine or an organic amine salt, most preferably an alkylamine or tetraalkylammonium hydroxide. These alkali catalysts may be used either individually or in combination of two or more.

Examples of the metal chelate catalyst include titanium chelate compounds such as triethoxymono(acetylacetonato)titanium, tri-n-propoxy·mono(acetylacetonato)titanium, tri-i-propoxy·mono(acetylacetonato)titanium, tri-n-butoxy·mono(acetylacetonato)titanium, tri-sec-butoxy·mono(acetylacetonato)titanium, tri-t-butoxy·mono(acetylacetonato)titanium, diethoxy·bis(acetylacetonato)titanium, di-n-propoxy·bis(acetylacetonato)titanium, di-i-propoxy·bis(acetylacetonato)titanium, di-n-butoxy·bis(acetylacetonato)titanium, di-sec-butoxy·bis(acetylacetonato)titanium, di-t-butoxy·bis(acetylacetonato)titanium, monoethoxy·tris(acetylacetonato)titanium, mono-n-propoxy·tris(acetylacetonato)titanium, mono-i-propoxy·tris(acetylacetonato)titanium, mono-n-butoxy·tris(acetylacetonato)titanium, mono-sec-butoxy·tris(acetylacetonato)titanium, mono-t-butoxy·tris(acetylacetonato)titanium, tetrakis(acetylacetonato)titanium, triethoxy·mono(ethyl acetoacetate)titanium, tri-n-propoxy·mono(ethyl acetoacetate)titanium, tri-i-propoxy·mono(ethyl acetoacetate)titanium, tri-n-butoxy·mono(ethyl acetoacetate)titanium, tri-sec-butoxy·mono(ethyl acetoacetate)titanium, tri-t-butoxymono(ethyl acetoacetate)titanium, diethoxy·bis(ethyl acetoacetate)titanium, di-n-propoxy·bis(ethyl acetoacetate)titanium, di-i-propoxy·bis(ethyl acetoacetate)titanium, di-n-butoxybis(ethyl acetoacetate)titanium, di-sec-butoxy.bis(ethyl acetoacetate)titanium, di-t-butoxybis(ethyl acetoacetate)titanium, monoethoxy·tris(ethyl acetoacetate)titanium, mono-n-propoxy·tris(ethyl acetoacetate)titanium, mono-i-propoxy·tris(ethyl acetoacetate)titanium, mono-n-butoxy·tris(ethyl acetoacetate)titanium, mono-sec-butoxy·tris(ethyl acetoacetate)titanium, mono-t-butoxy·tris(ethyl acetoacetate)titanium, tetrakis(ethyl acetoacetate)titanium, mono(acetylacetonato)tris(ethyl acetoacetate)titanium, bis(acetylacetonato)bis(ethyl acetoacetate)titanium, and tris(acetylacetonato)mono(ethyl acetoacetate)titanium; zirconium chelate compounds such as triethoxy·mono(acetylacetonato)zirconium, tri-n-propoxy·mono(acetylacetonato)zirconium, tri-i-propoxy·mono(acetylacetonato)zirconium, tri-n-butoxy·mono(acetylacetonato)zirconium, tri-sec-butoxy·mono(acetylacetonato)zirconium, tri-t-butoxy·mono(acetylacetonato)zirconium, diethoxy·bis(acetylacetonato)zirconium, di-n-propoxy·bis(acetylacetonato)zirconium, di-i-propoxy·bis(acetylacetonato)zirconium, di-n-butoxy·bis(acetylacetonato)zirconium, di-sec-butoxy·bis(acetylacetonato)zirconium, di-t-butoxy·bis(acetylacetonato)zirconium, monoethoxy·tris(acetylacetonato)zirconium, mono-n-propoxy·tris(acetylacetonato)zirconium, mono-i-propoxy·tris(acetylacetonato)zirconium, mono-n-butoxy·tris(acetylacetonato)zirconium, mono-sec-butoxy·tris(acetylacetonato)zirconium, mono-t-butoxy·tris(acetylacetonato)zirconium, tetrakis(acetylacetonato)zirconium, triethoxymono(ethyl acetoacetate)zirconium, tri-n-propoxy·mono(ethyl acetoacetate)zirconium, tri-i-propoxy·mono(ethyl acetoacetate)zirconium, tri-n-butoxy·mono(ethyl acetoacetate)zirconium, tri-sec-butoxy·mono(ethyl acetoacetate)zirconium, tri-t-butoxy·mono(ethyl acetoacetate)zirconium, diethoxy·bis(ethyl acetoacetate)zirconium, di-n-propoxy·bis(ethyl acetoacetate)zirconium, di-i-propoxy·bis(ethyl acetoacetate)zirconium, di-n-butoxy·bis(ethyl acetoacetate)zirconium, di-sec-butoxy·bis(ethyl acetoacetate)zirconium, di-t-butoxy·bis(ethyl acetoacetate)zirconium, monoethoxy·tris(ethyl acetoacetate)zirconium, mono-n-propoxy·tris(ethyl acetoacetate)zirconium, mono-i-propoxy·tris(ethyl acetoacetate)zirconium, mono-n-butoxy·tris(ethyl acetoacetate)zirconium, mono-sec-butoxy·tris(ethyl acetoacetate)zirconium, mono-t-butoxy·tris(ethyl acetoacetate)zirconium, tetrakis(ethyl acetoacetate)zirconium, mono(acetylacetonato)tris(ethyl acetoacetate)zirconium, bis(acetylacetonato)bis(ethyl acetoacetate)zirconium, and tris(acetylacetonato)mono(ethyl acetoacetate)zirconium; aluminum chelate compounds such as tris(acetylacetonato)aluminum, tris(ethyl acetoacetate)aluminum; and the like. Of these, titanium or aluminum chelate compounds are preferable, with titanium chelate compounds being particularly preferable. These metal chelate catalysts may be used either individually or in combination of two or more.

As examples of the acid catalyst, inorganic acids such as hydrochloric acid, nitric acid, sulfuric acid, hydrofluoric acid, phosphoric acid, and boric acid; and organic acids such as acetic acid, propionic acid, butanoic acid, pentanoic acid, hexanoic acid, heptanoic acid, octanoic acid, nonanoic acid, decanoic acid, oxalic acid, maleic acid, methylmalonic acid, adipic acid, sebacic acid, gallic acid, butyric acid, mellitic acid, arachidonic acid, shikimic acid, 2-ethylhexanoic acid, oleic acid, stearic acid, linolic acid, linoleic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, sulfonic acid, phthalic acid, fumaric acid, citric acid, tartaric acid, succinic acid, fumaric acid, itaconic acid, mesaconic acid, citraconic acid, malic acid, hydrolysate of glutaric acid, hydrolysate of maleic anhydride, and hydrolysate of phthalic anhydride can be given. Of these, organic carboxylic acids are preferable. These acid catalysts may be used either individually or in combination of two or more.

The catalyst is used in an amount of usually 0.00001 to 10 mol, and preferably 0.00005 to 5 mol for 1 mol of the total amount of the groups represented by X, Y, and Z in the compounds 2 and 3. If the amount of the catalyst is in the above range, precipitation or gelation of the polymer occurs to only a small extent during the reaction. In the invention, the temperature when hydrolyzing the compounds 2 and 3 is usually 0 to 100°C, and preferably 15 to 80°C.

In the invention, the term "complete hydrolysis-condensation product" refers to a product in which the hydrolyzable groups in the polycarbosilane (A) and the compounds 2 and 3 are completely hydrolyzed into SiOH groups and are completely condensed to form a siloxane structure.

The hydrolysis-condensation product is preferably a hydrolysis-condensation product of the polycarbosilane (A) and the compound 2, since the resulting composition exhibits excellent storage stability. In the invention, the compounds 2 and 3 are used so that the total amount of the compounds 2 and 3 is 500 to 4000 parts by weight, and preferably 1000 to 3000 parts by weight for 100 parts by weight of the polycarbosilane (A).

### 1.2.2. Organic solvent

In the film-forming composition according to the invention, the hydrolysis-condensation product may be dissolved or dispersed in an organic solvent together with other components described later, as required.

The organic solvent used as the component of the film-forming composition according to the invention is not particularly limited insofar as the organic solvent can be removed before obtaining the target film. As specific examples of the organic solvent, a protic solvent and a nonprotic solvent can be given. As an example of the protic solvent, an alcohol solvent can be given. As examples of the nonprotic solvent, a ketone solvent, an ester solvent, an ether solvent, an amide solvent, and other nonprotic solvents described later can be given.

Examples of the alcohol solvent include monohydric alcohol solvents such as methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, and diacetone alcohol; polyhydric alcohol solvents such as ethylene glycol, 1,2-polyethylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, and tripropylene glycol; polyhydric alcohol partial ether solvents such as ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, and dipropylene glycol monopropyl ether; and the like. These alcohol solvents may be used either individually or in combination of two or more.

Examples of the ketone solvent include acetone, methyl ethyl ketone, methyl n-propyl ketone, methyl n-butyl ketone, diethyl ketone, methyl i-butyl ketone, methyl n-pentyl ketone, ethyl n-butyl ketone, methyl n-hexyl ketone, di-i-butyl ketone, trimethylnonane, cyclohexanone, 2-hexanone, methylcyclohexanone, 2,4-pentanedione, acetonylacetone, acetophenone, and fenchone; beta-diketones such as acetylacetone, 2,4-hexanedione, 2,4-heptanedione, 3,5-heptanedione, 2,4-octanedione, 3,5-octanedione, 2,4-nonanedione, 3,5-nonanedione, 5-methyl-2,4-hexanedione, 2,2,6,6-tetramethyl-3,5-heptanedione, and 1,1,1,5,5,5-hexafluoro-2,4-heptanedione; and the like. These ketone solvents may be used either individually or in combination of two or more.

Examples of the amide solvent include formamide, N-methylformamide, N,N-dimethylformamide, N-ethylformamide, N,N-diethylformamide, acetamide, N-methylacetamide, N,N-dimethylacetamide, N-ethylacetamide, N,N-diethylacetamide, N-methylpropioneamide, N-methylpyrrolidone, N-formylmorpholine, N-formylpiperidine, N-formylpyrrolidine, N-acetylmorpholine, N-acetylpiperidine, N-acetylpyrrolidine, and the like. These amide solvents may be used either individually or in combination of two or more.

Examples of the ester solvent include diethyl carbonate, ethylene carbonate, propylene carbonate, diethyl carbonate, methyl acetate, ethyl acetate, gamma-butyrolactone, gamma-valerolactone, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, diethyl phthalate, and the like. These ester solvents may be used either individually or in combination of two or more.

Examples of the nonprotic solvent include acetonitrile, dimethylsulfoxide, N,N,N',N'-tetraethylsulfonamide, hexamethylphosphoric acid triamide, N-methylmorphorone, N-methylpyrrole, N-ethylpyrrole, N-methyl-delta₃-pyrroline, N-methylpiperidine, N-ethylpiperidine, N,N-dimethylpiperazine, N-methylimidazole, N-methyl-4-piperidone, N-methyl-2-piperidone, N-methyl-2-pyrrolidone, 1,3-dimethyl-2-imidazolidinone, 1,3-dimethyltetrahydro-2(1H)-pyrimidinone, and the like. These nonprotic solvents may be used either individually or in combination of two or more.

As the nonprotic solvent, the ketone solvents such as 2-heptanone, methyl isobutyl ketone, diethyl ketone, and cyclohexanone are preferable. As the alcohol solvent, propylene glycol monopropyl ether and the like are preferable.

The total solid content of the film-forming composition according to the invention thus obtained may be appropriately adjusted according to the application. The total solid content is preferably 2 to 30 wt%. If the total solid content of the film-forming composition is 2 to 30 wt%, the resulting coating has an appropriate thickness, and the composition exhibits excellent storage stability. The total solid content may be adjusted by concentration or dilution with the above organic solvent, as required.

### 1.2.3. Other components

The film-forming composition of the invention may not include a reaction accelerator for promoting the hydrolysis and/or condensation of the component (A) and/or the component (B). The term "reaction accelerator" means one of, or a combination of two or more of, a reaction initiator, a catalyst (acid generator or base generator), and a sensitizer having an electron beam absorption function.

A silica film obtained by curing the composition using an acid generator or a base generator generally contains a large amount of residual silanols to exhibit high hygroscopicity. As a result, a film with a high dielectric constant is obtained. A composition containing an acid generator or a base generator may not ensure the quality as an insulating film for LSI semiconductor devices for which high insulation reliability is required, since the acid generator, the base generator, or an acidic or basic material generated therefrom serves as a charge carrier to impair the insulating properties of the film or cause deterioration of a wiring metal.

On the other hand, the film-forming composition according to the invention can prevent such a problem since the coating can be cured by heating and application of electron beams, even if the film-forming composition does not contain such a reaction accelerator.

In the film-forming composition according to the invention, it is preferable that the sodium content, the potassium content, and the iron content be respectively 100 ppb or less. Since these elements contaminate semiconductor devices, it is preferable that these elements be excluded from the film-forming composition according to the invention.

A component such as an organic polymer, a surfactant, or a silane coupling agent may be added to the film-forming composition according to the invention. These additives may be added to the solvent in which each component is dissolved or dispersed before producing the film-forming composition.

### 1.2.3-1. Organic polymer

The organic polymer used in the invention may be added as a readily decomposable component for forming pores in the silica film. Addition of such an organic polymer is disclosed in JP-A-2000-290590, JP-A-2000-313612, and Hedrick, J. L. et al. "Templating Nanoporosity in Thin Film Dielectric Insulators", Adv. Mater., 10 (13), 1049, 1998, and the like. A similar organic polymer may be added.

As examples of the organic polymer, a polymer having a sugar chain structure, vinyl amide polymer, (meth)acrylic polymer, aromatic vinyl compound polymer, dendrimer, polyimide, polyamic acid, polyarylene, polyamide, polyquinoxaline, polyoxadiazole, fluorine polymer, polymer having a polyalkylene oxide structure, and the like can be given.

### 1.2.3-2. Surfactant

As examples of the surfactant, a nonionic surfactant, an anionic surfactant, a cationic surfactant, an amphoteric surfactant, and the like can be given. Specific examples include a fluorine-containing surfactant, a silicone surfactant, a polyalkylene oxide surfactant, a poly(meth)acrylate surfactant, and the like.

As examples of the fluorine-containing surfactant, compounds in which at least the terminal, the main chain, or the side chain includes a fluoroalkyl or fluoroalkylene group, such as 1,1,2,2-tetrafluorooctyl(1,1,2,2-tetrafluoropropyl)ether, 1,1,2,2-tetrafluorooctylhexyl ether, octaethylene glycol di(1,1,2,2-tetrafluorobutyl) ether, hexaethylene glycol (1,1,2,2,3,3-hexafluoropentyl) ether, octapropylene glycol di(1,1,2,2-tetrafluorobutyl) ether, hexapropylene glycol di(1,1,2,2,3,3-hexafluoropentyl) ether, sodium perfluorododecylsulfonate, 1,1,2,2,8,8,9,9,10,10-decafluorododecane, 1,1,2,2,3,3-hexafluorodecane, N-3-(perfluorooctanesulfonamide)-propyl-N,N'-dimethyl-N-carboxymethylene ammonium betaine, perfluoroalkyl sulfonamide propyltrimethyl ammonium salt, perfluoroalkyl-N-ethylsulfonylglycine salt, bis(N-perfluorooctylsulfonyl-N-ethylaminoethyl) phosphate, and monoperfluoroalkylethyl phosphate can be given.

As examples of commercially available products of the fluorine-containing surfactant, Megafac F142D, F172, F173, F183 (manufactured by Dainippon Ink and Chemicals, Inc.), Eftop EF301, EF303, EF352 (manufactured by Shin-Akita Kasei Co., Ltd.). Fluorad FC-430, FC-431 (manufactured by Sumitomo 3M, Ltd.), Asahi Guard AG710, Surflon S-382, SC-101, SC-102, SC-103, SC-104, SC-105, SC-106 (manufactured by Asahi Glass Co., Ltd.), BM-1000, BM-1100 (manufactured by BM Chemie), NBX-15 (manufactured by NEOS Co., Ltd.), and the like can be given. Of these, Megafac F172, BM-1000, BM-1100, and NBX-15 are preferable.

As the silicone surfactant, SH7PA, SH21PA, SH28PA, SH30PA, ST94PA (manufactured by Toray-Dow Coming Silicone Co., Ltd.) and the like may be used. Of these, SH28PA and SH30PA are preferable.

The surfactant is used in an amount of usually 0.00001 to 1 part by weight for 100 parts by weight of the film-forming composition. These silane coupling agents may be used either individually or in combination of two or more.

### 1.2.3-3. Silane coupling agent

As examples of the silane coupling agent, 3-glycidyloxypropyltrimethoxysilane, 3-aminoglycidyloxypropyltriethoxysilane,3-methacryloxypropyltrimethoxysilane, 3-glycidyloxypropylmethyldimethoxysilane, 1-methacryloxypropylmethyldimethoxysilane, 3-aminopropyltrimethoxysilane, 3-aminopropyltriethoxysilane, 2-aminopropyltrimethoxysilane, 2-aminopropyltriethoxysilane, N-(2-aminoethyl)-3-aminopropyltrimethoxysilane, N-(2-aminoethyl)-3-aminopropylmethyldimethoxysilane, 3-ureidopropyltrimethoxysilane, 3-ureidopropyltriethoxysilane, N-ethoxycarbonyl-3-aminopropyltrimethoxysilane, N-ethoxycarbonyl-3-aminopropyltriethoxysilane, N-triethoxysilylpropyltriethylenetriamine, N-triethoxysilylpropyltriethylenetriamine, 10-trimethoxysilyl-1,4,7-triazadecane, 10-triethoxysilyl-1,4,7-triazadecane, 9-trimethoxysilyl-3,6-diazanonylacetate, 9-triethoxysilyl-3,6-diazanonylacetate, N-benzyl-3-aminopropyltrimethoxysilane, N-benzyl-3-aminopropyltriethoxysilane, N-phenyl-3-aminopropyltrimethoxysilane, N-phenyl-3-aminopropyltriethoxysilane, N-bis(oxyethylene)-3-aminopropyltrimethoxysilane, N-bis(oxyethylene)-3-aminopropyltriethoxysilane, and the like can be given. These silane coupling agents may be used either individually or in combination of two or more.

### 1.3. Formation of organic silica film

The method of forming an organic silica film according to the invention includes forming the coating including the silicon compound on the substrate, heating the coating, and curing the coating by applying electron beams, as described above.

In the method of forming an organic silica film according to the invention, the coating may be heated while applying electron beams. In the curing treatment according to the invention, the organic silica sol can be sufficiently condensed at a relatively low temperature in a short time by heating the coating while applying electron beams, whereby the objective organic silica film according to the invention can be obtained. When heating the coating while applying electron beams, the curing treatment may be performed for preferably 30 seconds to 10 minutes, and still more preferably 30 seconds to 7 minutes. Each step of the method of forming an organic silica film according to the invention is described below.

### 1.3.1. Formation of coating

In the method of forming an organic silica film according to the invention, a coating method such as spin coating, dip coating, roll coating, or spraying is used when forming the coating including the silicon compound. The application target substrate is not particularly limited. As examples of the substrate, Si-containing layers such as Si, SiO₂, SiN, SiC, SiCN, and SiON can be given. As a specific example of the substrate, a semiconductor substrate formed of the above material can be given.

### 1.3.2. Heating of coating

The resulting coating is then dried at an ordinary temperature or dried by heating at about 80 to 600°C for 5 to 240 minutes to form a glass-like or high-molecular-weight polymer coating.

As the heating method, a hot plate, an oven, a furnace, or the like may be used. The coating may be heated in air, nitrogen, or argon, under vacuum, or under reduced pressure in which the oxygen concentration is controlled.

### 1.3.3. Application of electron beams to coating

In the method of forming an organic silica film according to the invention, electron beams are applied at an energy (accelerating voltage) of 0.1 to 20 keV and a dose of 1 to 1000 microcurie/cm² (preferably 10 to 500 microcurie/cm², and still more preferably 10 to 300 microcurie/cm²). If the accelerating voltage is 0.1 to 20 keV, electron beams can sufficiently enter the coating without passing through the film to damage a semiconductor device under the coating. If the dose of electron beams is 1 to 1000 microcurie/cm², the entire coating can be reacted, and damage to the coating is decreased.

The heating temperature of the substrate when applying electron beams is usually 300 to 450°C. If the heating temperature is lower than 300°C, the mobility of the molecular chain in the organic silica sol is not increased, whereby a sufficiently high condensation rate cannot be achieved. If the heating temperature is higher than 450°C, the molecules in the organic silica sol tend to decompose. Moreover, a heating temperature of higher than 450°C hinders a step in a semiconductor device manufacturing process such as a copper damascene process which is usually carried out at 450°C or less. As the heating means used when applying electron beams, a hot plate, infrared lamp annealing, or the like may be used. The time required to cure the coating by applying electron beams is generally 1 to 5 minutes, which is significantly shorter than the time required to thermally cure the coating (15 minutes to 2 hours). Therefore, application of electron beams is suitable for a single-wafer process.

The coating according to the invention may be thermally cured before applying electron beams in a state in which the substrate is heated at 250°C or more and 500°C or less to form an organic silica film with a relative dielectric constant of 3.0 or less (preferably 2.7 or less), and electron beams may be applied to the resulting organic silica film. A variation in thickness due to a nonuniform dose of electron beams can be reduced by applying electron beams after thermally curing the coating.

In the method of forming an organic silica film according to the invention, the coating may be heated stepwise or an atmosphere such as nitrogen, air, or oxygen, or reduced pressure may be selected in order to control the curing rate of the coating.

The coating according to the invention may be cured in an inert atmosphere or under reduced pressure. In the curing treatment, it is preferable to apply electron beams in the absence of oxygen. The term "absence of oxygen" used herein refers to a partial pressure of oxygen of preferably 0.1 kPa or less, and still more preferably 0.01 kPa or less. If the partial pressure of oxygen is higher than 0.1 kPa, ozone is produced during application of electron beams. The silicon compound is oxidized by the produced ozone to increase the hydrophilicity of the resulting organic silica film, whereby the hygroscopicity and the relative dielectric constant of the film tend to be increased. Therefore, an organic silica film which exhibits high hydrophobicity and is increased in relative dielectric constant to only a small extent can be obtained by performing the curing treatment in the absence of oxygen.

In the invention, electron beams may be applied in an inert gas atmosphere. As examples of the inert gas, N₂, He, Ar, Kr, and Xe (preferably He and Ar) can be given. The film is rarely oxidized by applying electron beams in an inert gas atmosphere, whereby the low dielectric constant of the resulting coating can be maintained.

In the invention, electron beams may be applied in a pressurized atmosphere or under reduced pressure. The pressure is preferably 0.001 to 1000 kPa, and still more preferably 0.001 to 101.3 kPa. If the pressure is outside the above range, the degree of curing may become nonuniform in a plane. In order to control the curing rate of the coating, the coating may be heated stepwise, or the atmospheric conditions such as an inert gas (e.g. nitrogen) or reduced pressure may be selected, as required.

Since the method of forming an organic silica film according to the invention includes heating the coating including the silicon compound and curing the coating by applying electron beams, the coating can be cured at a lower dose of electron beams in a shorter time at a lower temperature.

### 1.4. Organic silica film

The organic silica film according to the invention is obtained by the above method of forming an organic silica film according to the invention. In the organic silica film according to the invention, the carbon content (number of atoms) is 13 to 24 mol%, and preferably 13 to 20 mol%. If the carbon content is within the above range, the coating can be cured at a lower dose of electron beams, and the mechanical strength of the resulting organic silica film can be improved while maintaining a low relative dielectric constant. If the carbon content is less than 13 mol%, the reaction is not sufficiently promoted, even if electron beams are applied, due to the high diffusion barrier in the solid phase reaction. If the carbon content exceeds 24 mol%, the mobility of the molecules is increased to a large extent, whereby a film which exhibits a low modulus of elasticity and may exhibit glass transition is obtained.

The organic silica film according to the present invention exhibits an extremely high modulus of elasticity and film density and shows a low dielectric constant, as is clear from the examples described later. In more detail, the film density of the organic silica film according to the invention is usually 0.7 to 1.3 g/cm³, preferably 0.7 to 1.2 g/cm³, and still more preferably 0.7 to 1.0 g/cm³. If the film density is less than 0.7 g/cm³, the coating may exhibit insufficient mechanical strength. If the film density exceeds 1.3 g/cm³, a low relative dielectric constant may not be obtained. The relative dielectric constant of the organic silica film according to the invention is usually 1.5 to 3.5, preferably 1.9 to 3.1, and still more preferably 2.0 to 3.0. Therefore, the organic silica film according to the invention exhibits extremely excellent insulating film characteristics such as mechanical strength and relative dielectric constant.

The organic silica film according to the invention has a contact angle of water of preferably 60° or more, and still more preferably 70° or more. This indicates that the organic silica film according to the invention is hydrophobic. Since the organic silica film exhibits low hygroscopicity, a low relative dielectric constant can be maintained. The organic silica film is rarely damaged by RIE used in a semiconductor process due to low hygroscopicity. Moreover, the organic silica film exhibits excellent chemical resistance to a wet cleaning solution. In particular, an organic silica film with a relative dielectric constant k of 2.5 or less in which the insulating film has a porous structure significantly shows this tendency.

As described above, the organic silica film according to the invention has characteristics such as (a) exhibiting excellent insulating film characteristics such as relative dielectric constant, modulus of elasticity, plasma resistance, and chemical resistance and being able to be formed at a low temperature in a short time since the silicon compound has a specific composition and carbon content, (b) containing no contaminants for semiconductor devices since the film-forming composition according to the invention used to form the coating does not contain a source of an ionic substance, a charge carrier, or a corrosive compound such as an acid generator, a base generator, and a sensitizer sensitive to electron beams, (c) allowing a curing method to be employed which damages a transistor structure formed by a semiconductor process such as RIE to only a small extent and is carried out by a single-wafer process, (d) capable of maintaining a low relative dielectric constant due to high hydrophobicity and low hygroscopicity, and (e) exhibiting excellent mechanical strength such as modulus of elasticity to withstand formation of a copper damascene structure. The above characteristics provide excellent insulating properties, coating uniformity, dielectric constant properties, modulus of elasticity of the coating, adhesion of the coating, plasma resistance, and chemical resistance.

Since the organic silica film according to the invention exhibits a low relative dielectric constant and excellent mechanical strength, adhesion, plasma resistance, and chemical resistance, the organic silica film according to the invention can be suitably used for applications such as an interlayer dielectric for semiconductor devices such as an LSI, system LSI, DRAM, SDRAM, RDRAM, and D-RDRAM, an etching stopper film, a protective film (e.g. surface coating film) for semiconductor devices, an intermediate layer used in a semiconductor manufacturing step using a multilayer resist, an interlayer dielectric for multilayer wiring boards, and a protective film or an insulating film for liquid crystal display elements. The organic silica film according to the invention can be suitably used for semiconductor devices including a wiring structure such as a copper damascene wiring structure.

### 2. Example

The invention is described below in more detail by way of examples. Note that the invention is not limited to the following examples. In the examples and comparative examples, "part" and "%" respectively refer to "part by weight" and "wt%" unless otherwise indicated.

### 2.1. Evaluation method

Each item was evaluated as follows.

### 2.1.1. Weight average molecular weight (Mw) of polymer

The weight average molecular weight (Mw) of the polymer was measured by gel permeation chromatography (GPC) under the following conditions.
Sample: A sample was prepared by dissolving 1 g of the polymer in 100 cc of tetrahydrofuran (solvent).
Standard polystyrene: Standard polystyrene manufactured by Pressure Chemical Company was used.
Instrument: high-temperature high-speed gel permeation chromatogram (Model 150-C ALC/GPC) manufactured by Waters Corporation
Column: SHODEX A-80M (length: 50 cm) manufactured by Showa Denko K.K.
Measurement temperature: 40°C
Flow rate: 1 cc/min

### 2.1.2. Relative dielectric constant

An aluminum electrode pattern was formed on the resulting polymer film by deposition to prepare a relative dielectric constant measurement sample. The relative dielectric constant of the sample was measured at room temperature by a CV method at a frequency of 100 kHz using an electrode HP16451B and a precision LCR meter HP4284A manufactured by Yokogawa-Hewlett-Packard, Ltd.

### 2.1.3 Delta k

The relative dielectric constant was measured at 200°C in the same manner as in 2.1.2, and the difference between the measured relative dielectric constant and the relative dielectric constant measured in 2.1.2 was calculated.

### 2.1.4. Mechanical strength (modulus of elasticity)

The mechanical strength of the resulting polymer was measured using a surface acoustic wave (SAW) method.

### 2.1.5. Plasma resistance measurement method

After applying ammonia plasma to the cured organic silica film for 30 seconds, the relative dielectric constant of the film was measured. The film was evaluated according to an increase in the relative dielectric constant due to application of plasma.
A: The increase in the relative dielectric constant was less than 0.2.
B: The increase in the relative dielectric constant was 0.2 or more and less than 0.5.
C: The increase in the relative dielectric constant was 0.5 or more.

### 2.1.6 Chemical resistance test

The cured organic silica film was immersed in a triethanolamine aqueous solution (12 pH) at room temperature for 10 minutes, and washed with water. After drying waterdrops on the surface using a nitrogen blow, the relative dielectric constant of the film was measured. The film was evaluated according to an increase in the relative dielectric constant due to the test.
A: The increase in the relative dielectric constant was less than 0.1.
B: The increase in the relative dielectric constant was 0.1 or more and less than 0.3.
C: The increase in the relative dielectric constant was 0.3 or more.

### 2.1.7. Carbon content

In each synthesis example, the carbon content in a hydrolysis-condensation product obtained when silane monomers used to synthesize a silicon compound (hydrolysis-condensation product) were completely hydrolyzed and condensed was calculated.

### 2.2. Examples and Comparative Examples

### 2.2.1. Synthesis Example 1

In a separable flask made of quartz, 2.2 g of a polycarbosilane A1 (weight average molecular weight: 800) having a structural unit of the following formula (4), 33.3 g of methyltrimethoxysilane, 21.8 g of tetraethoxysilane, and 0.0031 g of triethylamine were dissolved in 250 g of ethanol. The mixture was stirred using a three-one motor, and the solution temperature was stabilized at 55°C. A mixed solution of 50.4 g of ion-exchanged water and 203.2 g of propylene glycol monoethyl ether was added to the solution in one hour.

After allowing the mixture to react at 55°C for four hours, 10 g of a 10% propylene glycol monopropyl ether solution of acetic acid was added to the mixture. After allowing the mixture to react for 30 minutes, the reaction liquid was cooled to room temperature. 298 g of a solution containing methanol and water was removed from the reaction liquid by evaporation at 50°C to obtain a film-forming composition A containing a hydrolysis-condensation product with a carbon content of 13.2 mol%, a weight average molecular weight of 45,000, and an Si-CH₂-Si/Si-O-Si ratio (molar ratio) of 0.034. The film-forming composition (hereinafter may be simply called "composition") had a sodium content of 0.5 ppb, a potassium content of 0.8 ppb, and an iron content of 0.7 ppb.

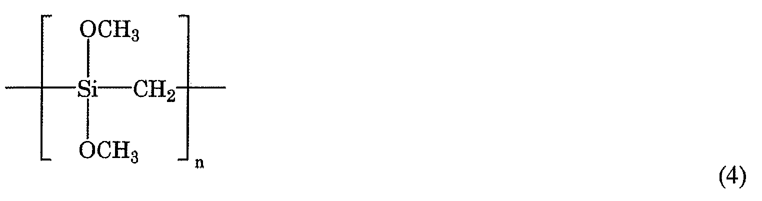

### 2.2.2. Synthesis Example 2

In a separable flask made of quartz, 8.4 g of the polycarbosilane A1 used in Synthesis Example 1, 33.4 g of methyltrimethoxysilane, 9.0 g of tetraethoxysilane, and 0.0030 g of triethylamine were dissolved in 253 g of methanol. The mixture was stirred using a three-one motor, and the solution temperature was stabilized at 55°C. A mixed solution of 50.2 g of ion-exchanged water and 200.3 g of propylene glycol monoethyl ether was added to the solution in one hour.

After allowing the mixture to react at 55°C for four hours, 10 g of a 10% propylene glycol monopropyl ether solution of acetic acid was added to the mixture. After allowing the mixture to react for 30 minutes, the reaction liquid was cooled to room temperature. 299 g of a solution containing methanol and water was removed from the reaction liquid by evaporation at 50°C to obtain a film-forming composition B containing a hydrolysis-condensation product with a carbon content of 15.3 mol%, a weight average molecular weight of 42,000, and an Si-CH₂-Si/Si-O-Si ratio (molar ratio) of 0.153. The composition B had a sodium content of 1.1 ppb, a potassium content of 0.4 ppb, and an iron content of 0.6 ppb.

### 2.2.3. Synthesis Example 3

In a separable flask made of quartz, 16.4 g of a polycarbosilane A2 (weight average molecular weight: 750) having a structural unit of the following formula (5), 21.3 g of methyltrimethoxysilane, 5.7 g of tetraethoxysilane, and 248 g of methanol were dissolved in 201 g of a propylene glycol monopropyl ether solution. The mixture was stirred using a three-one motor, and the solution temperature was stabilized at 55°C. Then, 24 g of ion-exchanged water, in which 0.12 g of succinic acid was dissolved, was added to the solution in one hour. After allowing the mixture to react at 50°C for three hours, the reaction liquid was cooled to room temperature. 272 g of a solution containing water was removed from the reaction liquid by evaporation at 50°C to obtain a film-forming composition C containing a hydrolysis-condensation product with a carbon content of 19.7 mol%, a weight average molecular weight of 3200, and an Si-CH₂-Si/Si-O-Si ratio (molar ratio) of 0.487. The composition C had a sodium content of 0.7 ppb, a potassium content of 0.5 ppb, and an iron content of 0.8 ppb.

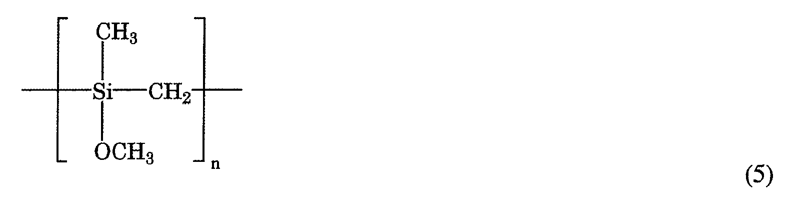

### 2.2.4. Synthesis Example 4

In a separable flask made of quartz, 32.8 g of the polycarbosilane A2 used in Synthesis Example 3 and 248 g of methanol were dissolved in 201 g of a propylene glycol monopropyl ether solution. The mixture was stirred using a three-one motor, and the solution temperature was stabilized at 55°C. Then, 20 g of ion-exchanged water, in which 0.08 g of succinic acid was dissolved, was added to the solution in one hour. After allowing the mixture to react at 50°C for three hours, the reaction liquid was cooled to room temperature. 250 g of a solution containing water was removed from the reaction liquid by evaporation at 50°C to obtain a film-forming composition D containing a hydrolysis-condensation product with a carbon content of 23.5 mol%, a weight average molecular weight of 2700, and an Si-CH₂-Si/Si-O-Si ratio (molar ratio) of 2.00. The composition D had a sodium content of 0.8 ppb, a potassium content of 0.5 ppb, and an iron content of 0.9 ppb.

### 2.2.5. Synthesis Example 5

In a separable flask made of quartz, 50.4 g of methyltrimethoxysilane, 77.1 g of tetraethoxysilane, and 0.0034 g of triethylamine were dissolved in 267 g of methanol. The mixture was stirred using a three-one motor, and the solution temperature was stabilized at 55°C. A mixed solution of 56.2 g of ion-exchanged water and 200.3 g of propylene glycol monoethyl ether was added to the solution in one hour.

After allowing the mixture to react at 55°C for four hours, 10 g of a 10% propylene glycol monopropyl ether solution of acetic acid was added to the mixture. After allowing the mixture to react for 30 minutes, the reaction liquid was cooled to room temperature. 299 g of a solution containing methanol and water was removed from the reaction liquid by evaporation at 50°C to obtain a film-forming composition E containing a hydrolysis-condensation product with a carbon content of 10.5 mol%, a weight average molecular weight of 45,000, and an Si-CH₂-Si/Si-O-Si ratio (molar ratio) of 0.000. The composition E had a sodium content of 0.6 ppb, a potassium content of 0.7 ppb, and an iron content of 0.9 ppb.

### 2.2.6. Synthesis Example 6

In a separable flask made of quartz, 4.9 g of a polycarbosilane A3 (weight average molecular weight: 2300) having a structural unit of the following formula (6), 20.5 g of methyltrimethoxysilane, 31.3 g of tetraethoxysilane, and 258 g of methanol were dissolved in 209 g of a propylene glycol monopropyl ether solution. The mixture was stirred using a three-one motor, and the solution temperature was stabilized at 55°C. Then, 20 g of ion-exchanged water, in which 0.08 g of succinic acid was dissolved, was added to the solution in one hour. After allowing the mixture to react at 60°C for 12 hours, the reaction liquid was cooled to room temperature. 250 g of a solution containing water was removed from the reaction liquid by evaporation at 50°C to obtain a film-forming composition F containing a hydrolysis-condensation product with a carbon content of 16.7 mol%, a weight average molecular weight of 4400, and an Si-CH₂-Si/Si-O-Si ratio (molar ratio) of 0.132. The composition F had a carbon content of 16.7 mol%, a sodium content of 0.8 ppb, a potassium content of 0.5 ppb, and an iron content of 0.9 ppb.

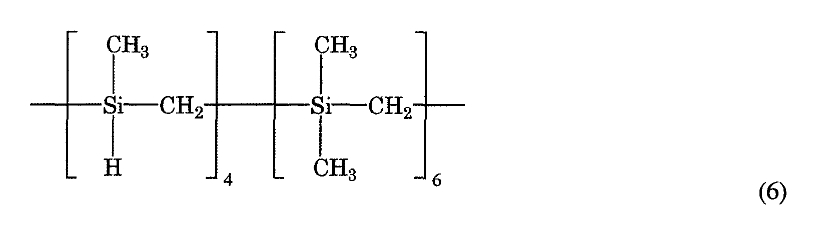

### 2.3. Examples and Comparative Examples

Each of the compositions obtained in Synthesis Examples 1 to 6 was applied to a silicon wafer by spin coating. The substrate was dried on a hot plate at 90°C for three minutes and at 200°C for three minutes in a nitrogen atmosphere, and sintered under the curing conditions shown in Table 1. The resulting polymer film (hereinafter called "silica film") was evaluated according to the above evaluation methods. The evaluation results are shown in Table 1. In Examples 1 to 6, the coating was cured by applying electron beams at a specific dose during heating under the conditions shown in Table 1. In Comparative Examples 1 to 5, the coating was cured by only heating.

The IR spectra of the silica films obtained in Example 2 and Comparative Example 2 were measured. The results are shown in FIG. 1. In FIG. 1, peaks which appear after EB application are observed at the points indicated by A and B.

**TABLE 1**

| | Composition | | Heating condition | | Electron beam application condition | | Evaluation result | | | | | |
|---|---|---|---|---|---|---|---|---|---|---|---|---|
| | | | Temperature (°C) | Time (min) | EB dose (microcurie/cm²) | Accelerating voltage | Thickness after curing (nm) | Relative dielectric constant | Delta k | Modulus of elasticity (Gpa) | Plasma resistance | Chemical resistance |
| Comparative Example 1 | A | Only heating | 350 | 60 | - | - | 250 | 2.4 | 0.19 | 3.0 | B | B |
| Example 1 | A | EB | 350 | 3 | 50 | 5 | 250 | 2.35 | 0.08 | 4.1 | A | A |
| Example 2 | B | EB | 300 | 7 | 150 | 7 | 500 | 2.2 | 0.05 | 5.5 | A | A |
| Comparative Example 2 | B | EB | 350 | 60 | - | - | 500 | 2.3 | 0.11 | 4.9 | B | B |
| Comparative Example 3 | C | Only heating | 400 | 60 | - | - | 500 | 3.1 | 0.38 | 6.2 | A | B |
| Example 3 | C | Only heating | 350 | 5 | 250 | 7 | 500 | 2.85 | 0.09 | 14.5 | A | A |
| Example 4 | D | EB | 350 | 10 | 1000 | 10 | 1000 | 3.0 | 0.15 | 15.0 | A | A |
| Comparative Example 4 | E | EB | 400 | 5 | 150 | 7 | 500 | 2.3 | 0.18 | 4.4 | C | C |
| Comparative Example 5 | E | Only heating | 400 | 60 | - | - | 500 | 2.25 | 0.10 | 4.5 | C | C |
| Example 6 | F | EB | 400 | 5 | 150 | 7 | 500 | 2.8 | 0.09 | 11.5 | A | A |
| Comparative Example 5 | F | Only heating | 400 | 60 | - | - | 500 | 2.9 | 0.23 | 5.3 | B | B |

As is clear from the above results, it was confirmed that Examples 1 to 6 allow formation of an organic silica film which exhibits significantly improved characteristics (particularly modulus of elasticity) in comparison with Comparative Examples 1 to 5. Therefore, the organic silica film obtained according to the invention exhibits excellent mechanical strength, a low relative dielectric constant, and low hygroscopicity, and may be suitably used as an interlayer dielectric for semiconductor devices and the like.

## Claims

1. A method of forming an organic silica film comprising forming a coating including a silicon compound having an -Si-O-Si- structure and an -Si-CH₂-Si- structure on a substrate, heating the coating, and curing the coating by applying electron beams.

2. The method of forming an organic silica film according to claim 1, wherein the silicon compound contains the -Si-O-Si- structure and the -Si-CH₂-Si- structure at an -Si-CH₂-Si-/-Si-O-Si- ratio (molar ratio) of 0.03 to 2.00.

3. The method of forming an organic silica film according to claim 1, wherein the silicon compound has a carbon content of 13 to 24 mol % .

4. The method of forming an organic silica film according to claim 1, wherein the silicon compound is a hydrolysis-condensation product obtained by hydrolyzing and condensing (B) a hydrolyzable-group-containing silane monomer in the presence of (A) a polycarbosilane.

5. The method of forming an organic silica film according to claim 1, wherein the electron beams are applied at an accelerating voltage of 0.1 to 20 keV and a dose of 1 to 1000 microcurie/cm².

6. The method of forming an organic silica film according to claim 1, wherein the coating is heated while applying the electron beams.

7. The method of forming an organic silica film according to claim 1, wherein the coating is heated at 300 to 450°C.

8. The method of forming an organic silica film according to claim 1, wherein the electron beams are applied in the absence of oxygen.

9. An organic silica film obtained by the method of forming an organic silica film according to any of claims 1 to 8 and having a relative dielectric constant of 1.5 to 3.5 and a film density of 0.7 to 1.3 g/cm³.

10. A wiring structure comprising the organic silica film according to claim 9 as an interlayer dielectric.

11. A semiconductor device comprising the wiring structure according to claim 10.

12. A film-forming composition comprising a hydrolysis-condensation product obtained by hydrolyzing and condensing (B) a hydrolyzable-group-containing silane monomer in the presence of (A) a polycarbosilane, and an organic solvent, and used in the method of forming an organic silica film according to any of claims 1 to 8 to form the coating.

13. The film-forming composition according to claim 12, wherein the hydrolysis-condensation product contains carbon atoms in an amount of 13 to 24 mol%.

14. The film-forming composition according to claim 12, wherein the amount of the component (B) is 1 to 1000 parts by weight for 100 parts by weight of the component (A) as a complete hydrolysis-condensation product.

15. The film-forming composition according to claim 12, having a sodium content, a potassium content, and an iron content of 100 ppb or less, respectively.
